# EUROPÄISCHE PATENTANMELDUNG

(11) **EP 4 276 536 A1**
(43) Veröffentlichungstag der Anmeldung: **15.11.2023**
(21) Anmeldenummer: 22172287.9
(22) Anmeldetag: 09.05.2022
(51) Int. Cl.: G03F 7/12, G03F 7/20

(54) **KOMPAKTE LICHTQUELLEN-ANORDNUNG UND DEREN VERWENDUNG BEI DER HERSTELLUNG VON SIEBDRUCKSCHABLONEN**

(71) Anmelder: CST GmbH, 47809 Krefeld (DE)
(72) Erfinder: KESPER, Peer, 47800 Krefeld (DE)
(74) Vertreter: Cohausz & Florack

(57) **Zusammenfassung**

Die Erfindung betrifft eine Lichtquellen-Anordnung. Die Aufgabe, eine kompakte und kostengünstige Lichtquellen-Anordnung zur Erzeugung eines Lichtstrahlbündels anzugeben, wird dadurch gelöst, dass die Lichtquellen-Anordnung (100) mindestens eine Lichtquelleneinheit (110), mindestens eine Spiegeleinheit (120) und mindestens einen optischen Diffusor (130) umfasst, wobei die mindestens eine Lichtquelleneinheit (110) eine Vielzahl von gleichartigen Lichtquellen (111) umfasst, welche jeweils ein Maximum der abgestrahlten Lichtstärke entlang einer Richtung aufweisen und so angeordnet sind, dass die Richtungen mit maximaler Lichtstärke der jeweiligen Lichtquellen (111) im Wesentlichen parallel zueinander sind, wobei die mindestens eine Spiegeleinheit (120) mindestens zwei ebene Spiegel (121) umfasst, welche im Wesentlichen parallel zueinander und versetzt zueinander angeordnet sind, sodass die mindestens zwei ebenen Spiegel (121) eine stufenförmige Anordnung bilden, wobei die von der Vielzahl von Lichtquellen (111) ausgesandten Lichtstrahlen zumindest teilweise von den mindestens zwei ebenen Spiegeln (121) auf mindestens eine Eintrittsoberfläche (131) des mindestens einen optischen Diffusors (130) reflektiert werden, an der mindestens einen Eintrittsoberfläche (131) des mindestens einen optischen Diffusors (130) zumindest teilweise in das Volumen (132) des mindestens einen optischen Diffusors (130) eintreten, in dem Volumen (132) des mindestens einen optischen Diffusors (130) zumindest teilweise gestreut werden, und an mindestens einer Austrittsoberfläche (133) des mindestens einen optischen Diffusors (130) zumindest teilweise aus dem mindestens einen optischen Diffusor (130) als Lichtstrahlbündel (161) austreten.

## Beschreibung

Die vorliegende Erfindung betrifft eine Lichtquellen-Anordnung. Ferner betrifft die Erfindung ein Verfahren und eine Vorrichtung zur Herstellung einer Siebdruckschablone.

Beim Siebdruck wird die Druckfarbe durch ein Siebdruckgewebe hindurch auf das Druckmedium gedruckt. Zur Erzeugung des Druckbilds wird vor dem eigentlichen Druckvorgang eine Siebdruckschablone auf das Siebdruckgewebe aufgebracht. An denjenigen Stellen des Siebdruckgewebes, wo keine Farbe gedruckt werden soll, werden die Maschenöffnungen des Siebdruckgewebes durch die Siebdruckschablone verschlossen und damit farbundurchlässig gemacht. An den übrigen Stellen des Siebdruckgewebes bleiben die Maschenöffnungen geöffnet und farbdurchlässig. Für den Druck wird das Siebdruckgewebe üblicherweise auf einen rechteckigen Rahmen gespannt; es sind aber auch zylinderförmige Siebdruckformen bekannt, bei denen sich das Siebdruckgewebe als Zylindermantel zwischen zwei Endringen erstreckt.

Die technische Herstellung einer Siebdruckschablone erfolgt üblicherweise durch selektive Belichtung einer photosensitiven Schicht. In der Regel wird eine flüssige photosensitive Schicht selektiv belichtet, wobei die belichteten Stellen aushärten ("negative resist"), während die nicht belichteten Stellen mit einem Lösungsmittel ausgewaschen werden können. Jedoch lassen sich Siebdruckschablonen auch herstellen, indem eine feste photosensitive Schicht selektiv belichtet wird, wobei die belichteten Stellen löslich werden ("positive resist") und mit einem Lösungsmittel ausgewaschen werden können, während die nicht belichteten Stellen fest bleiben. In beiden Fällen wird für die selektive Belichtung im Allgemeinen nicht nur Licht in dem für das menschliche Auge sichtbaren Wellenlängenbereich verwendet, sondern insbesondere auch Ultraviolett-Strahlung. Insofern umfasst der Begriff "Licht" im Rahmen dieser Patentanmeldung nicht nur elektromagnetische Strahlung im sichtbaren Wellenlängenbereich, sondern darüber hinaus auch die angrenzenden Bereiche des Ultraviolett (UV) sowie des Infrarot (IR).

Für die selektive Belichtung wird unter anderem die sogenannte DLP-Technik (Direct Light Processing) angewendet. Dabei wird ein Lichtstrahlbündel auf einen Flächenlichtmodulator, insbesondere auf einen sogenannten DMD-Chip (Digital Micromirror Device), gerichtet und von dort auf die photosensitive Schicht projiziert. Ein DMD-Chip umfasst eine Vielzahl von matrixförmig angeordneten verkippbaren Mikrospiegeln mit einer Kantenlänge im Bereich von einigen µm. Jeder einzelne Mikrospiegel kann durch elektrostatische Felder, welche bei entsprechender elektronischer Ansteuerung des DMD-Chips erzeugt werden, zwischen zwei stabilen Endzuständen verkippt werden. Je nach Kippposition der Mikrospiegel werden kleine Ausschnitte des einfallenden Lichtstrahlbündels jeweils entweder in die Projektionsrichtung hinein oder aus der Projektionsrichtung heraus reflektiert. Dadurch, dass die einzelnen Mikrospiegel bis zu mehrere tausend Mal pro Sekunde ihre Kippposition verändern können, kann auf diese Weise sowohl eine zeitliche als auch eine örtliche Variation der Lichtintensität innerhalb des in Projektionsrichtung reflektierten Lichtstrahlbündels erreicht werden.

Der Begriff "Lichtintensität" bezeichnet im Rahmen dieser Patentanmeldung die Strahlungsflussdichte, auch Bestrahlungsstärke genannt, der Lichtstrahlung, welche als Strahlungsleistung pro Fläche definiert ist und in der SI-Einheit Watt pro Quadratmeter angegeben wird. Ferner bezeichnet der Begriff "Lichtstärke" die auf den Raumwinkel bezogene Strahlungsleistung, welche in der SI-Einheit Watt pro Steradiant angegeben wird. Eine Gewichtung mit dem photometrischen Strahlungsäquivalent wird sowohl bei der "Lichtintensität" als auch bei der "Lichtstärke" im Rahmen dieser Patentanmeldung nicht vorgenommen, da der Begriff "Licht", wie oben erwähnt, auch elektromagnetische Strahlung in dem für das menschliche Auge nicht sichtbaren Wellenlängenbereich umfasst.

Bei der DLP-Technik ist der Querschnitt des projizierten Lichtstrahlbündels üblicherweise kleiner als die Oberfläche der photosensitiven Schicht. Deshalb wird in der Regel ein Belichtungskopf, welcher eine Lichtquellen-Anordnung zur Erzeugung des Lichtstrahlbündels sowie den DMD-Chip umfasst, über die photosensitive Schicht bewegt. Der DMD-Chip wird während dieser Bewegung so angesteuert, dass die photosensitive Schicht durch die auf ihrer Oberfläche lokal auftreffende Lichtintensität des projizierten Lichtstrahlbündels entsprechend eines vorgegebenen Druckbilds selektiv aushärtet beziehungsweise selektiv löslich wird. Um die gesamte Oberfläche der photosensitiven Schicht zu erfassen, kann der Belichtungskopf kontinuierlich, beispielsweise in parallelen Bahnen, über die Oberfläche geführt werden. Alternativ können einzelne Ausschnitte der Oberfläche nacheinander belichtet werden. Auf diese Weise wird schließlich eine dem gewünschten Druckbild entsprechende Siebdruckschablone hergestellt. In manchen Fällen wird die Siebdruckschablone im Anschluss an das DLP-Verfahren noch nachgehärtet. Falls die Oberfläche der photosensitiven Schicht kleiner ist als der Querschnitt des projizierten Lichtstrahlbündels, kann die Bewegung des Belichtungskopfs auch entfallen.

Als Lichtquellen-Anordnung zur Erzeugung des Lichtstrahlbündels wird bei der DLP-Technik konventionell eine einzelne Lichtquelle verwendet und aus dem abgestrahlten Licht wird mittels optischer Systeme ein aufgeweitetes Lichtstrahlbündel erzeugt. Das aufgeweitete Lichtstrahlbündel, welches auf den DMD-Chip gerichtet wird, weist zwar die erforderlichen Eigenschaften wie insbesondere eine ausreichende Parallelität auf. Die Aufweitung hat jedoch den Nachteil, dass hierfür komplizierte optische Systeme, beispielsweise in Form von Objektiven, welche eine Vielzahl von Linsen umfassen, benötigt werden, was hohe Kosten mit sich bringt.

Ebenfalls bekannt ist eine Lichtquellen-Anordnung, bei der das Licht aus mehreren einzelnen Lichtquellen jeweils in einem Lichtleiter geführt wird und die einzelnen Lichtleiter vereinigt werden, wobei der daraus resultierende Lichtleiter einen größeren Querschnitt aufweist als die einzelnen Lichtleiter vor der Vereinigung. Auf diese Weise entsteht ebenso ein für die DLP-Technik geeignetes Lichtstrahlbündel. Nachteilig an dieser Anordnung ist jedoch der hohe Platzbedarf, da bei der Führung der Lichtleiter keine starken Krümmungen möglich sind.

Vor diesem Hintergrund liegt der vorliegenden Erfindung die Aufgabe zugrunde, eine kompakte und kostengünstige Lichtquellen-Anordnung zur Erzeugung eines Lichtstrahlbündels anzugeben. Ferner hat sich der Erfindung die Aufgabe gestellt, ein Verfahren und eine Vorrichtung zur Herstellung einer Siebdruckschablone anzugeben, bei dem/der die Erzeugung des Lichtstrahlbündels mit geringem Platzbedarf und ohne die Notwendigkeit komplizierter optischer Systeme erfolgt.

Gemäß einer ersten Lehre der vorliegenden Erfindung wird die oben genannte Aufgabe für eine Lichtquellen-Anordnung dadurch gelöst, dass die Lichtquellen-Anordnung mindestens eine Lichtquelleneinheit, mindestens eine Spiegeleinheit und mindestens einen optischen Diffusor umfasst, wobei die mindestens eine Lichtquelleneinheit eine Vielzahl von gleichartigen Lichtquellen umfasst, welche jeweils ein Maximum der abgestrahlten Lichtstärke entlang einer Richtung aufweisen und so angeordnet sind, dass die Richtungen mit maximaler Lichtstärke der jeweiligen Lichtquellen im Wesentlichen parallel zueinander sind, wobei die mindestens eine Spiegeleinheit mindestens zwei ebene Spiegel umfasst, welche im Wesentlichen parallel zueinander und versetzt zueinander angeordnet sind, sodass die mindestens zwei ebenen Spiegel eine stufenförmige Anordnung bilden, wobei die von der Vielzahl von Lichtquellen ausgesandten Lichtstrahlen zumindest teilweise von den mindestens zwei ebenen Spiegeln auf mindestens eine Eintrittsoberfläche des mindestens einen optischen Diffusors reflektiert werden, an der mindestens einen Eintrittsoberfläche des mindestens einen optischen Diffusors zumindest teilweise in das Volumen des mindestens einen optischen Diffusors eintreten, in dem Volumen des mindestens einen optischen Diffusors zumindest teilweise gestreut werden, und an mindestens einer Austrittsoberfläche des mindestens einen optischen Diffusors zumindest teilweise aus dem mindestens einen optischen Diffusor als Lichtstrahlbündel austreten.

Die Lichtquelleneinheit der erfindungsgemäßen Lichtquellen-Anordnung umfasst eine Vielzahl von gleichartigen Lichtquellen. Hierunter werden zwei oder mehr Lichtquellen verstanden, welche jeweils das gleiche physikalische Prinzip zur Lichterzeugung benutzen. Beispielsweise können die gleichartigen Lichtquellen jeweils das Prinzip einer Glühlampe, einer Lichtbogenlampe, einer Gasentladungslampe, einer Leuchtdiode, eines Lasers oder einer Laserdiode benutzen. Gleichartig bedeutet jedoch nicht zwingend, dass die Lichtquellen exakt identisch sind. Insbesondere bedeutet gleichartig nicht zwingend, dass die Lichtquellen allesamt Licht derselben Wellenlänge oder mit derselben spektralen Verteilung ausstrahlen. Dadurch, dass die Lichtquellen-Anordnung eine Vielzahl von gleichartigen Lichtquellen umfasst, kann die ausgehende Lichtleistung der Lichtquellen-Anordnung einfach skaliert und variiert werden. Beispielsweise kann durch Veränderung der Anzahl von gleichartigen Lichtquellen die maximale Ausgangsleistung der Lichtquellen-Anordnung an eine bestimmte Anwendung angepasst werden. Ferner ist im Betrieb der Lichtquellen-Anordnung eine Variation der Ausgangsleistung durch das An- oder Ausschalten einzelner Lichtquellen möglich. Schließlich kann der Ausfall einer oder mehrerer Lichtquellen im Betrieb durch Erhöhung der Lichtleistung der noch funktionierenden Lichtquellen kompensiert werden.

Erfindungsgemäß weisen die gleichartigen Lichtquellen der Lichtquelleneinheit jeweils ein Maximum der abgestrahlten Lichtstärke entlang einer Richtung auf und sind so angeordnet, dass die Richtungen mit maximaler Lichtstärke im Wesentlichen parallel zueinander sind. Beispielsweise kann es sich bei den Lichtquellen um Laser oder Laserdioden handeln, welche eine hohe Bündelung, d.h. ein stark ausgeprägtes Maximum der abgestrahlten Lichtstärke entlang einer Richtung aufweisen. Unter einer im Wesentlichen parallelen Anordnung wird in diesem Zusammenhang eine Anordnung verstanden, bei der die Winkel zwischen den Richtungen mit maximaler Lichtstärke der Lichtquellen um höchstens 5°, vorzugsweise um höchstens 2°, voneinander abweichen. Dadurch, dass die Richtungen mit maximaler Lichtstärke im Wesentlichen parallel zueinander sind, kann die Verlustleistung der Lichtquellen-Anordnung reduziert werden, da ein größerer Teil der von den einzelnen Lichtquellen ausgestrahlten Lichtstrahlen über die mindestens eine Spiegeleinheit in den mindestens einen optischen Diffusor gelangt. Daneben lässt sich mit der im Wesentlichen parallelen Anordnung der Lichtquellen auch eine größere Tiefenschärfe erreichen. Dies gilt insbesondere dann, wenn Lichtquellen mit hoher Bündelung wie beispielsweise Laserdioden verwendet werden.

Die Spiegeleinheit der erfindungsgemäßen Lichtquellen-Anordnung umfasst mindestens zwei ebene Spiegel, welche im Wesentlichen parallel zueinander und versetzt zueinander angeordnet sind, sodass die mindestens zwei ebenen Spiegel eine stufenförmige Anordnung bilden. Unter einer im Wesentlichen parallelen Anordnung wird in diesem Zusammenhang eine Anordnung verstanden, bei der die Winkel zwischen den Flächennormalen der ebenen Spiegel um höchstens 5°, vorzugsweise um höchstens 2°, voneinander abweichen. Dadurch, dass die mindestens zwei ebenen Spiegel der Spiegeleinheit eine stufenförmige Anordnung bilden, kann auf platzsparende Weise erreicht werden, dass ein großer Teil des von den einzelnen Lichtquellen der Lichtquelleneinheit ausgestrahlten Lichts in den mindestens einen optischen Diffusor gelangt.

Erfindungsgemäß wird das Licht, welches an der mindestens einen Eintrittsoberfläche des mindestens einen optischen Diffusors zumindest teilweise in das Volumen des mindestens einen optischen Diffusors eintritt, in dem Volumen des mindestens einen optischen Diffusors zumindest teilweise gestreut. Die Streuung des Lichts kann beispielsweise durch diffuse Reflexion und/oder durch Brechung erfolgen. Beispielsweise weist der mindestens eine optische Diffusor in seinem Volumen hierfür eine Vielzahl von Streuzentren auf. Beispielsweise besteht der mindestens eine optische Diffusor aus Glas. Beispielsweise handelt es sich bei den Streuzentren um Lufteinschlüsse im Volumen des mindestens einen optischen Diffusors. Während die ortsabhängige Lichtintensität der Gruppe von Lichtstrahlen, welche an der mindestens einen Eintrittsoberfläche in den mindestens einen optischen Diffusor eintreten, vergleichsweise ungleichmäßig ist, wird durch die zumindest teilweise Streuung des Lichts in dem Volumen des mindestens einen optischen Diffusors eine weitgehende Homogenisierung der Lichtintensität erreicht, sodass das Lichtstrahlbündel, welches an der mindestens einen Austrittsoberfläche aus dem mindestens einen optischen Diffusor austritt, eine gleichmäßigere ortsabhängige Lichtintensität aufweist.

Dadurch, dass die erfindungsgemäße Lichtquellen-Anordnung lediglich mindestens eine Lichtquelleneinheit, mindestens eine Spiegeleinheit und mindestens einen optischen Diffusor umfasst, welche wie oben beschrieben zusammenwirken, kann eine besonders kompakte Anordnung zur Erzeugung eines Lichtstrahlbündels, verglichen beispielsweise mit einer Anordnung mehrerer Lichtleiter, bereitgestellt werden. Darüber hinaus ist die erfindungsgemäße Lichtquellen-Anordnung auch kostengünstig, da zur Erzeugung des Lichtstrahlbündels keine komplizierten optischen Systeme benötigt werden, insbesondere keine Objektive, welche eine Vielzahl von Linsen umfassen.

In einer bevorzugten Ausführungsform der erfindungsgemäßen Lichtquellen-Anordnung umfasst die Vielzahl von Lichtquellen der mindestens einen Lichtquelleneinheit mindestens zwei Gruppen von Lichtquellen, wobei allen Lichtquellen einer Gruppe gemeinsam ist, dass die von den jeweiligen Lichtquellen in Richtung der maximalen Lichtstärke abgestrahlten Lichtstrahlen auf dem gleichen ebenen Spiegel der mindestens einen Spiegeleinheit auftreffen. Hierdurch ist eine Verringerung des Platzbedarfs der erfindungsgemäßen Lichtquellen-Anordnung möglich, da die Anzahl der benötigten ebenen Spiegel der mindestens einen Spiegeleinheit verringert wird.

In einer weiteren bevorzugten Ausführungsform der erfindungsgemäßen Lichtquellen-Anordnung sind alle Lichtquellen einer Gruppe in einer Reihe angeordnet, falls die jeweilige Gruppe zwei oder mehr Lichtquellen umfasst. Die Anordnung in einer Reihe führt gegenüber einer unregelmäßigen Anordnung der Lichtquellen einer Gruppe zu einer weiteren Verringerung des Platzbedarfs.

In einer weiteren bevorzugten Ausführungsform der erfindungsgemäßen Lichtquellen-Anordnung umfasst jede der mindestens zwei Gruppen von Lichtquellen eine identische Anzahl von Lichtquellen. Hierdurch kann der von der Lichtquellen-Anordnung beanspruchte Raum besonders gut ausgenutzt werden, sodass eine kompakte Lichtquellen-Anordnung entsteht.

In einer weiteren bevorzugten Ausführungsform der erfindungsgemäßen Lichtquellen-Anordnung ist jede Lichtquelle der mindestens einen Lichtquelleneinheit eine Laserdiode. Aufgrund des geringen Platzbedarfs von Laserdioden kann die Kompaktheit der Lichtquellen-Anordnung dadurch weiter erhöht werden. Ferner weisen Laserdioden den Vorteil auf, dass sie ein stark ausgeprägtes Maximum der abgestrahlten Lichtstärke entlang einer Richtung aufweisen, wodurch die Verlustleistung der Lichtquellen-Anordnung verringert wird.

In einer weiteren bevorzugten Ausführungsform der erfindungsgemäßen Lichtquellen-Anordnung strahlt jede Lichtquelle der mindestens einen Lichtquelleneinheit Licht in einem Wellenlängenbereich zwischen 300 nm und 450 nm, bevorzugt zwischen 360 nm und 420 nm aus. Insbesondere strahlt jede Lichtquelle der mindestens einen Lichtquelleneinheit monochromatisches Licht mit einer Wellenlänge von 365 nm, 380 nm oder 405 nm aus. Licht der genannten Wellenlängenbereiche, ebenso wie monochromatisches Licht der genannten Wellenlängen, eignet sich besonders gut zur Belichtung der photosensitiven Schichten, die in der Siebdrucktechnik üblicherweise zur Herstellung von Siebdruckschablonen eingesetzt werden.

In einer weiteren bevorzugten Ausführungsform der erfindungsgemäßen Lichtquellen-Anordnung umfasst die mindestens eine Lichtquelleneinheit ferner eine gelochte Platte, an der die Vielzahl von Lichtquellen befestigt ist. Die gelochte Platte bewirkt eine sichere Befestigung der Lichtquellen auf geringem Raum und trägt dadurch zu einer kompakten Anordnung bei.

In einer weiteren bevorzugten Ausführungsform der erfindungsgemäßen Lichtquellen-Anordnung umfasst die mindestens eine Spiegeleinheit ferner ein stufenförmiges Element, welches die stufenförmige Anordnung der mindestens zwei ebenen Spiegel definiert. Beispielsweise kann das stufenförmige Element die stufenförmige Anordnung der mindestens zwei ebenen Spiegel dadurch definieren, dass die mindestens zwei ebenen Spiegel jeweils an im Wesentlichen parallelen und versetzt angeordneten Flächen des stufenförmigen Elements befestigt sind. Beispielsweise kann das stufenförmige Element die stufenförmige Anordnung der mindestens zwei ebenen Spiegel jedoch auch dadurch definieren, dass im Wesentlichen parallele und versetzt angeordnete Flächen des stufenförmigen Elements jeweils eine reflektierende Oberfläche aufweisen und dadurch die mindestens zwei ebenen Spiegel der Spiegeleinheit bilden. In beiden Fällen ermöglicht das stufenförmige Element eine einfache und sichere räumliche Anordnung der mindestens zwei ebenen Spiegel.

In einer weiteren bevorzugten Ausführungsform der erfindungsgemäßen Lichtquellen-Anordnung weist der mindestens eine optische Diffusor zumindest in einigen Oberflächenbereichen, welche weder eine Eintrittsoberfläche noch eine Austrittsoberfläche darstellen, eine reflektierende Oberfläche auf, sodass Lichtstrahlen, welche aus dem Volumen des mindestens einen optischen Diffusors auf die reflektierende Oberfläche des mindestens einen optischen Diffusors treffen, zumindest teilweise zurück in das Volumen des mindestens einen optischen Diffusors reflektiert werden. Hierdurch wird die Verlustleistung der Lichtquellen-Anordnung verringert, da zumindest teilweise verhindert wird, dass Lichtstrahlen an Stellen aus dem mindestens einen optischen Diffusor austreten, an denen sie nicht zur Lichtintensität des an der mindestens einen Austrittsoberfläche austretenden Lichtstrahlbündels beitragen.

In einer weiteren bevorzugten Ausführungsform der erfindungsgemäßen Lichtquellen-Anordnung umfasst die Lichtquellen-Anordnung ferner mindestens ein optisches Bauteil, insbesondere mindestens eine Blende und/oder mindestens eine Linse, welche/s entlang des Strahlengangs vor der mindestens einen Eintrittsoberfläche des mindestens einen optischen Diffusors angeordnet ist. Das mindestens eine optische Bauteil muss nicht zwingend unmittelbar vor der mindestens einen Eintrittsoberfläche angeordnet sein. Durch ein entsprechendes optisches Bauteil kann noch vor Eintritt der Lichtstrahlen in den mindestens einen optischen Diffusor eine Verbesserung in Bezug auf den Strahlengang erreicht werden. Durch Verwendung mindestens einer Linse kann beispielsweise eine bessere Fokussierung auf die mindestens eine Eintrittsoberfläche des mindestens einen optischen Diffusors erreicht werden. Durch Verwendung mindestens einer Blende kann beispielsweise unerwünschtes Streulicht absorbiert werden. Komplizierte optische Systeme, beispielsweise in Form von Objektiven, welche eine Vielzahl von Linsen umfassen, sind für die Realisierung einer erfindungsgemäßen Lichtquellen-Anordnung jedoch nicht erforderlich.

In einer weiteren bevorzugten Ausführungsform der erfindungsgemäßen Lichtquellen-Anordnung umfasst die Lichtquellen-Anordnung ferner mindestens ein optisches Bauteil, insbesondere mindestens eine Blende und/oder mindestens eine Linse, welche/s entlang des Strahlengangs nach der mindestens einen Austrittsoberfläche des mindestens einen optischen Diffusors angeordnet ist. Das mindestens eine optische Bauteil muss nicht zwingend unmittelbar nach der mindestens einen Austrittsoberfläche angeordnet sein. Durch ein entsprechendes optisches Bauteil kann nach Austritt des Lichtstrahlbündels aus dem mindestens einen optischen Diffusor eine Verbesserung in Bezug auf den Strahlengang erreicht werden. Beispielsweise kann sowohl durch Verwendung mindestens einer Linse als auch durch Verwendung mindestens einer Blende die Parallelität des ausgehenden Lichtstrahlbündels erhöht werden. Erneut sind komplizierte optische Systeme jedoch nicht erforderlich.

Eine zweite Lehre der vorliegenden Erfindung betrifft ein Verfahren zur Herstellung einer Siebdruckschablone durch selektive Belichtung einer photosensitiven Schicht, wobei mindestens ein Lichtstrahlbündel von mindestens einer Lichtquellen-Anordnung bereitgestellt wird, wobei das mindestens eine bereitgestellte Lichtstrahlbündel unter Verwendung mindestens eines Flächenlichtmodulators auf die photosensitive Schicht projiziert wird, wobei der mindestens eine Flächenlichtmodulator von mindestens einer Steuereinheit so angesteuert wird, dass das projizierte Lichtstrahlbündel die photosensitive Schicht entsprechend eines vorgegebenen Druckbilds selektiv belichtet. Gemäß der zweiten Lehre wird die oben genannte Aufgabe für ein solches Verfahren dadurch gelöst, dass das mindestens eine Lichtstrahlbündel von einer Lichtquellen-Anordnung gemäß der ersten Lehre bereitgestellt wird.

Dadurch, dass in dem erfindungsgemäßen Verfahren mindestens ein Lichtstrahlbündel von mindestens einer Lichtquellen-Anordnung bereitgestellt wird, kann das für die selektive Belichtung der photosensitiven Schicht benötigte Licht zur Verfügung gestellt werden. Dadurch, dass in dem erfindungsgemäßen Verfahren das mindestens eine bereitgestellte Lichtstrahlbündel unter Verwendung mindestens eines Flächenlichtmodulators auf die photosensitive Schicht projiziert wird, kann eine selektive Belichtung der photosensitiven Schicht erfolgen. Bei dem mindestens einen Flächenlichtmodulator handelt es sich insbesondere um mindestens einen DMD-Chip. Dadurch, dass in dem erfindungsgemäßen Verfahren der mindestens eine Flächenlichtmodulator von mindestens einer Steuereinheit so angesteuert wird, dass das projizierte Lichtstrahlbündel die photosensitive Schicht entsprechend eines vorgegebenen Druckbilds selektiv belichtet, kann eine dem vorgegebenen Druckbild entsprechende Siebdruckschablone hergestellt werden.

Erfindungsgemäß wird das mindestens eine Lichtstrahlbündel in dem Verfahren gemäß der zweiten Lehre von einer Lichtquellen-Anordnung gemäß der ersten Lehre bereitgestellt. Hierdurch kann die Erzeugung des Lichtstrahlbündels in dem erfindungsgemäßen Verfahren mit geringem Platzbedarf und ohne die Notwendigkeit komplizierter optischer Systeme erfolgen. Diesbezüglich wird auch auf die Ausführungen im Zusammenhang mit der ersten Lehre verwiesen.

Eine dritte Lehre der vorliegenden Erfindung betrifft eine Vorrichtung zur Herstellung einer Siebdruckschablone durch selektive Belichtung einer photosensitiven Schicht, wobei die Vorrichtung mindestens eine Lichtquellen-Anordnung, mindestens einen Flächenlichtmodulator und mindestens eine Steuereinheit umfasst. Gemäß der dritten Lehre wird die oben genannte Aufgabe für eine solche Vorrichtung dadurch gelöst, dass die Vorrichtung mindestens eine Lichtquellen-Anordnung gemäß der ersten Lehre umfasst. Hierdurch kann die Erzeugung des Lichtstrahlbündels durch die erfindungsgemäße Vorrichtung mit geringem Platzbedarf und ohne die Notwendigkeit komplizierter optischer Systeme erfolgen. Diesbezüglich wird auch auf die Ausführungen im Zusammenhang mit der ersten Lehre verwiesen.

Insbesondere erfolgt die Herstellung einer Siebdruckschablone mit der Vorrichtung gemäß der dritten Lehre unter Durchführung eines Verfahrens gemäß der zweiten Lehre. Hierzu sind die mindestens eine Lichtquellen-Anordnung, der mindestens eine Flächenlichtmodulator und die mindestens eine Steuereinheit zur Durchführung eines Verfahrens gemäß der zweiten Lehre eingerichtet. Bezüglich der technischen Wirkungen der mindestens einen Lichtquellen-Anordnung, des mindestens einen Flächenlichtmodulators und der mindestens einen Steuereinheit wird auf die Ausführungen im Zusammenhang mit der zweiten Lehre verwiesen.

Weitere Ausgestaltungen und Vorteile der Erfindung sind der folgenden detaillierten Beschreibung einiger beispielhafter Ausführungsformen der vorliegenden Erfindung, insbesondere in Verbindung mit der Zeichnung, zu entnehmen. Die Zeichnung zeigt in
- Fig. 1: eine schematische Darstellung einer Lichtquellen-Anordnung gemäß der ersten Lehre der Erfindung in einer Schnittansicht,
- Fig. 2: eine Schnittansicht senkrecht zu der durch die Punkte A und B in Fig. 1 definierten Ebene, und
- Fig. 3: eine schematische Darstellung einer Vorrichtung zur Herstellung einer Siebdruckschablone gemäß der dritten Lehre der Erfindung mit einer Lichtquellen-Anordnung gemäß der ersten Lehre der Erfindung.

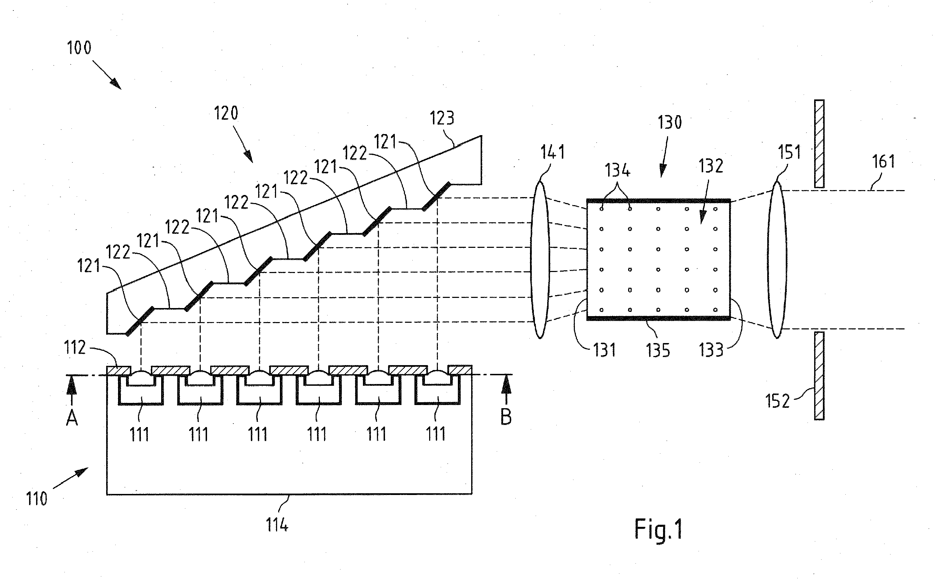

Fig. 1 zeigt zunächst eine schematische Darstellung einer Lichtquellen-Anordnung (100) gemäß der ersten Lehre der Erfindung in einer Schnittansicht. Die Lichtquellen-Anordnung (100) umfasst eine Lichtquelleneinheit (110), eine Spiegeleinheit (120) und einen optischen Diffusor (130). Die Lichtquelleneinheit (110) umfasst in dieser beispielhaften Ausführungsform insgesamt achtzehn gleichartige Lichtquellen (111), welche an einer gelochten Platte (112) befestigt sind. Aufgrund der Schnittansicht sind in Fig. 1 lediglich sechs der achtzehn Lichtquellen (111) dargestellt. Die Lichtquellen (111) weisen eine gerichtete Abstrahlcharakteristik auf, wobei die Richtungen mit maximaler Lichtstärke in Fig. 1 jeweils durch gestrichelte Linien dargestellt sind. Wie zu erkennen ist, sind die Richtungen mit maximaler Lichtstärke im Wesentlichen parallel zueinander, wodurch optische Streuverluste und damit auch die Verlustleistung der Lichtquellen-Anordnung (100) reduziert werden und außerdem eine größere Tiefenschärfe erreicht wird. Die Lichtquelleneinheit (110) umfasst ferner ein Gehäuse (114), in dem sich in dieser beispielhaften Ausführungsform Teile der Spannungsversorgung sowie Steuerelektronik für die Lichtquellen (111) befinden. Auf dem Gehäuse (114) sind außerdem Kühlrippen (nicht dargestellt) zur Abfuhr der anfallenden Abwärme angebracht. Eine Skalierung der maximalen Ausgangsleistung der Lichtquellen-Anordnung (100) wäre auf einfache Weise möglich, indem zusätzliche Lichtquellen (111) vorgesehen oder vorhandene Lichtquellen (111) entfernt werden. Ferner kann im Betrieb eine Variation der Ausgangsleistung der Lichtquellen-Anordnung (100) durch das An- oder Ausschalten einzelner Lichtquellen (111) erreicht werden.

Jede Lichtquelle (111) der Lichtquellen-Anordnung (100) ist eine Laserdiode (111). Hieraus ergeben sich die Vorteile eines geringen Platzbedarfs sowie einer Verringerung der Verlustleistung, da Laserdioden eine stark gerichtete Abstrahlcharakteristik aufweisen. Jede der achtzehn Laserdioden (111) strahlt Licht im Wellenlängenbereich zwischen 300 nm und 450 nm aus. Konkret strahlen die achtzehn Laserdioden (111) monochromatisches Licht der Wellenlängen 365 nm, 380 nm und 405 nm aus. In dieser beispielhaften Ausführungsform weisen sechs Laserdioden (111) eine Wellenlänge von 365 nm, sechs weitere Laserdioden (111) eine Wellenlänge von 380 nm und sechs weitere Laserdioden (111) eine Wellenlänge von 405 nm auf. Allgemein ist jedoch jede beliebige Kombination von Wellenlängen der Laserdioden (111) denkbar, wobei insbesondere auch alle Laserdioden (111) monochromatisches Licht derselben Wellenlänge ausstrahlen können. Das Licht der genannten Wellenlängen eignet sich besonders gut zur Belichtung der in der Siebdrucktechnik gängigen photosensitiven Schichten.

Die Spiegeleinheit (120) umfasst in dieser beispielhaften Ausführungsform sechs ebene Spiegel (121), welche im Wesentlichen parallel zueinander angeordnet sind. Ferner sind die sechs ebenen Spiegel (121) versetzt zueinander angeordnet. Aufgrund der Parallelität und des Versatzes bilden die ebenen Spiegel (121) eine stufenförmige Anordnung. Hierdurch gelangt ein großer Teil des von den Lichtquellen (111) ausgestrahlten Lichts in den optischen Diffusor (130), ohne dass hierfür, verglichen beispielsweise mit einer Anordnung mehrerer Lichtleiter, viel Platz beansprucht wird. Die Spiegeleinheit (120) umfasst in dieser beispielhaften Ausführungsform ferner ein stufenförmiges Element (123) in Form eines Spiegelträgers (123). Der Spiegelträger (123) weist Spiegelabschnitte und Stufenabschnitte (122) auf. An den sechs Spiegelabschnitten sind die ebenen Spiegel (121) befestigt. Die Stufenabschnitte (122) erzeugen einen Versatz zwischen den Spiegelabschnitten und damit auch zwischen den ebenen Spiegeln (121). Hierdurch definiert der Spiegelträger (123) die stufenförmige Anordnung der ebenen Spiegel (121). Ebenso wäre jedoch auch denkbar, dass die Spiegelabschnitte des Spiegelträgers (123) bereits verspiegelte Oberflächen aufweisen, sodass in diesem Fall der Spiegelträger (123) ebenfalls eine stufenförmige Anordnung von sechs ebenen Spiegeln definieren würde, ohne dass hierfür die separaten ebenen Spiegel (121) an dem Spiegelträger (123) befestigt werden müssten. Außerdem wäre es grundsätzlich auch möglich, die stufenförmige Anordnung der ebenen Spiegel anstelle der Stufenabschnitte (122) des Spiegelträgers (123) durch andere geeignete Maßnahmen zu realisieren.

Der optische Diffusor (130), der hier beispielhaft aus Glas besteht und zylinderförmig ist, umfasst eine Eintrittsoberfläche (131), ein Volumen (132) und eine Austrittsoberfläche (133), wobei Eintrittsoberfläche (131) und Austrittsoberfläche (133) durch die beiden Deckflächen des Zylinders gebildet werden. Wie Fig. 1 zeigt, wird zumindest ein Teil der von den Lichtquellen (111) ausgesandten Lichtstrahlen von den ebenen Spiegeln (121) auf die Eintrittsoberfläche (131) reflektiert. An der Eintrittsoberfläche (131) tritt ein Großteil der Lichtstrahlen in das Volumen (132) ein; lediglich ein sehr geringer Teil wird an der Eintrittsoberfläche (131) reflektiert. In dem Volumen (132) wird ein Teil der eingetretenen Lichtstrahlen gestreut und hierdurch abgelenkt. Der optische Diffusor (130) enthält hierzu in seinem Volumen (132) eine Vielzahl von Streuzentren (134) in Form von Lufteinschlüssen (134), an denen sowohl diffuse Reflexion als auch Brechung stattfindet. Schließlich tritt ein Teil der eingetretenen und teilweise gestreuten Lichtstrahlen an der Austrittsoberfläche (133) aus dem optischen Diffusor (130) als Lichtstrahlbündel (161) aus. Aufgrund der erfolgten Streuung weist das ausgetretene Lichtbündel (161) eine weitestgehend gleichmäßige ortsabhängige Lichtintensität auf. Ferner weist der optische Diffusor (130) im Bereich der Mantelfläche (135) des Zylinders eine reflektierende Oberfläche auf, sodass Lichtstrahlen, welche aus dem Volumen (132) auf die Mantelfläche (135) treffen, zu einem großen Teil zurück in das Volumen (132) reflektiert werden. Hierdurch wird die Verlustleistung der Lichtquellen-Anordnung (100) verringert.

Wie Fig. 1 zeigt, umfasst die Lichtquellen-Anordnung (100) ferner eine Linse (141), welche entlang des Strahlengangs vor der Eintrittsoberfläche (131) angeordnet ist. Hierdurch wird eine bessere Fokussierung der von den Lichtquellen (111) ausgestrahlten und an den ebenen Spiegeln (121) reflektierten Lichtstrahlen auf die Eintrittsoberfläche (131) erreicht. Darüber hinaus umfasst die Lichtquellen-Anordnung (100) auch eine Linse (151) und eine Blende (152), welche entlang des Strahlengangs nach der Austrittsoberfläche (133) angeordnet sind und jeweils die Parallelität des ausgehenden Lichtstrahlbündels (161) verbessern.

Die Lichtquellen-Anordnung (100) mit der Lichtquelleneinheit (110), der Spiegeleinheit (120) und dem optischen Diffusor (130), welche wie oben beschrieben zusammenwirken, stellt eine besonders kompakte Anordnung zur Erzeugung des Lichtstrahlbündels (161) dar. Darüber hinaus benötigt die Lichtquellen-Anordnung (100) keine komplizierten optischen Systeme, insbesondere keine Objektive, welche eine Vielzahl von Linsen umfassen, sodass die Lichtquellen-Anordnung (100) kostengünstig realisierbar ist.

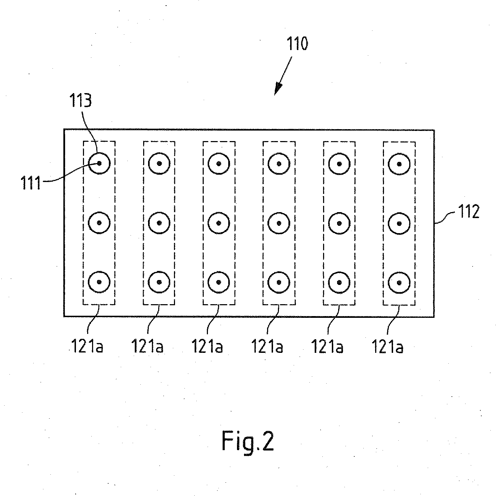

Fig. 2 zeigt eine Schnittansicht senkrecht zu der durch die Punkte A und B in Fig. 1 definierten Ebene. Zu sehen ist die gelochte Platte (112) der Lichtquelleneinheit (110). Die gelochte Platte (112) weist für jede der achtzehn Lichtquellen ein Loch (113) auf, also insgesamt achtzehn Löcher (113). Die Lichtquellen (111), deren Richtungen mit maximaler Lichtstärke jeweils durch einen Punkt dargestellt sind, befinden sich in dieser Ansicht auf der Rückseite hinter der gelochten Platte (112) und sind an der gelochten Platte (112) befestigt. Die Befestigung wird hier durch eine Schraubverbindung realisiert, wobei jedoch allgemein jede geeignete Art der Befestigung denkbar ist, beispielsweise auch eine Klebeverbindung. Ferner zeigt Fig. 2 Projektionen (121a) der ebenen Spiegel (121) in die Ebene der gelochten Platte (112), welche als Rechtecke mit gestrichelter Kontur dargestellt sind. Wie anhand von Fig. 2 ersichtlich ist, lassen sich die Lichtquellen (111), welche sich hinter den Löchern (113) befinden, in sechs Gruppen einteilen, wobei allen Lichtquellen einer Gruppe gemein ist, dass die von den Lichtquellen in Richtung der maximalen Lichtstärke abgestrahlten Lichtstrahlen auf dem gleichen ebenen Spiegel (121) der Spiegeleinheit (120) auftreffen. In Fig. 2 ist dies daran zu erkennen, dass sich jeweils drei Löcher (113) innerhalb eines Rechtecks mit gestrichelter Kontur, welches jeweils die Projektion (121a) eines ebenen Spiegels (121) darstellt, befinden. Diejenigen drei Lichtquellen, die sich jeweils hinter diesen drei Löchern (113) befinden, bilden eine Gruppe. Wie aus Fig. 2 ferner erkennbar ist, sind alle Lichtquellen (111) einer Gruppe in einer Reihe angeordnet. Zudem umfasst jede Gruppe eine identische Anzahl von Lichtquellen (111). In dieser beispielhaften Ausführungsform umfasst jede der sechs Gruppen drei Lichtquellen. Allgemein ist jedoch jede zweckmäßige Anzahl von Gruppen und Lichtquellen pro Gruppe denkbar. Die Anzahl der Gruppen von Lichtquellen (111) der Lichtquelleneinheit (110) entspricht dabei stets der Anzahl der ebenen Spiegel (121) der Spiegeleinheit (120). Sowohl die Anordnung der Lichtquellen (111) in Gruppen, als auch die Anordnung aller Lichtquellen einer Gruppe in einer Reihe, sowie die identische Anzahl von Lichtquellen pro Gruppe, führen jeweils zu einer besonders kompakten Lichtquellen-Anordnung (100).

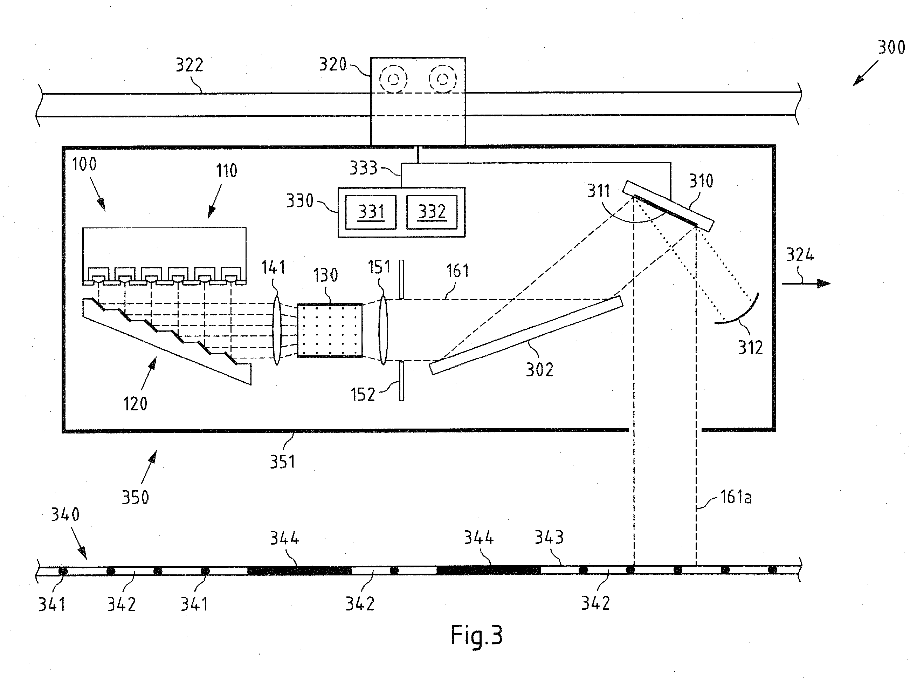

Fig. 3 zeigt eine schematische Darstellung einer Vorrichtung zur Herstellung einer Siebdruckschablone gemäß der dritten Lehre der Erfindung. Die Vorrichtung (300) ist dazu eingerichtet, eine auf einem Trägerobjekt (340) aufgebrachte photosensitive Schicht (342) selektiv zu belichten. Die Vorrichtung (300) umfasst eine Lichtquellen-Anordnung (100), einen Flächenlichtmodulator (310), ein Antriebsmittel (320) und eine Steuereinheit (330). Bei der Lichtquellen-Anordnung (100) handelt es sich um die in Fig. 1 dargestellte Lichtquellen-Anordnung (100) gemäß der ersten Lehre der Erfindung, wobei gleiche Elemente mit gleichen Bezugszeichen versehen sind. Allerdings sind in Fig. 3 die Lichtquelleneinheit (110) und die Spiegeleinheit (120) beispielhaft spiegelverkehrt in Bezug auf Fig. 1 angeordnet. Die Lichtquellen-Anordnung (100) gemäß der ersten Lehre erzeugt das Lichtstrahlbündel (161) mit geringem Platzbedarf und ohne die Notwendigkeit komplizierter optischer Systeme.

Die Vorrichtung (300) ist dazu eingerichtet, ein Verfahren gemäß der zweiten Lehre durchzuführen. Dazu stellt die Lichtquellen-Anordnung (100) das Lichtstrahlbündel (161) bereit, wie im Zusammenhang mit Fig. 1 beschrieben. Das Lichtstrahlbündel (161) wird auf den Flächenlichtmodulator (310) gerichtet. In Fig. 3 wird das Lichtstrahlbündel über einen Spiegel (302) auf den Flächenlichtmodulator (310) gerichtet. Der Spiegel (302) verbessert die Kompaktheit der Vorrichtung (300), ist jedoch für die Realisierung der Vorrichtung (300) nicht zwingend erforderlich. Bei dem Flächenlichtmodulator (310) handelt es sich um einen DMD-Chip (310). Von dem DMD-Chip (310) wird das bereitgestellte Lichtstrahlbündel (161) auf die Oberfläche (343) der photosensitiven Schicht (342) projiziert. Die matrixförmig angeordneten Mikrospiegel des DMD-Chips, die sich in dem Bereich (311) befinden, sind hierzu durch elektronische Ansteuerung des DMD-Chips (310) zwischen zwei stabilen Endzuständen verkippbar. Diejenigen Mikrospiegel, die sich in einer ersten Kippposition befinden, reflektieren jeweils kleine Ausschnitte des Lichtstrahlbündels (161) in die Projektionsrichtung, welche in Fig. 3 senkrecht nach unten verläuft. Die entsprechend reflektierten Ausschnitte bilden zusammen das projizierte Lichtstrahlbündel (161a). Diejenigen Mikrospiegel, die sich in einer zweiten Kippposition befinden, reflektieren jeweils andere Ausschnitte des Lichtstrahlbündels (161) aus der Projektionsrichtung heraus. Die entsprechend reflektierten Ausschnitte treffen auf einen Absorber (312), welcher die Lichtstrahlen absorbiert.

Das Antriebsmittel (320) ist hier beispielhaft ein elektrischer Motor, der über Stromzuleitungen (nicht dargestellt) mit Energie versorgt wird. Die Lichtquellen-Anordnung (100), der Spiegel (302), der DMD-Chip (310), der Absorber (312) und die Steuereinheit (330) befinden sich in einem Gehäuse (351), welches mit dem Antriebsmittel (320) verbunden ist. Das Gehäuse (351) mit den sich darin befindlichen Komponenten sowie das Antriebsmittel (320) bilden zusammen einen Belichtungskopf (350), der an einer Führungsschiene (322) aufgehängt ist. Durch Ansteuerung des Antriebsmittels (320) kann der Belichtungskopf (350) entlang der Führungsschiene (322) in Richtung des Pfeils (324) über die Oberfläche (343) der photosensitiven Schicht (342) bewegt werden. Zudem kann die Führungsschiene (322) durch separate Antriebsmittel (nicht dargestellt) in der Richtung senkrecht zur Zeichenebene bewegt werden. Somit kann das projizierte Lichtstrahlbündel (161a) über die gesamte Oberfläche (343) der photosensitiven Schicht (342) bewegt werden.

Die Steuereinheit (330) umfasst einen Prozessor (331) sowie einen Speicher (332) und ist über Steuerleitungen (333) mit dem DMD-Chip (310), dem Antriebsmittel (320), sowie dem nicht dargestellten separaten Antriebsmittel, welches die Bewegung der Führungsschiene (322) in der Richtung senkrecht zur Zeichenebene ermöglicht, verbunden. Die Steuereinheit (330) befindet sich hier exemplarisch innerhalb des Belichtungskopfs (350); sie könnte jedoch ohne weiteres auch außerhalb des Belichtungskopfs (350) vorgesehen sein. Insbesondere könnte es sich bei der Steuereinheit (330) um einen externen Steuerrechner handeln, der mit der Vorrichtung (300) verbunden ist. Bei der Durchführung eines Verfahrens gemäß der zweiten Lehre steuert die Steuereinheit den DMD-Chip (310), das Antriebsmittel (320), sowie das nicht dargestellten separaten Antriebsmittel, welches die Bewegung der Führungsschiene (322) in der Richtung senkrecht zur Zeichenebene ermöglicht, an. Dabei werden einerseits die beiden Antriebsmittel so angesteuert, dass der Belichtungskopf (350) und damit auch das projizierte Lichtstrahlbündel (161a) eine Relativbewegung in Bezug auf die Oberfläche (343) der photosensitiven Schicht (342) ausführt. Andererseits wird der DMD-Chip (310) während der Bewegung des Belichtungskopfs so angesteuert, dass entsprechend eines vorgegebenen Druckbilds eine selektive Belichtung der photosensitiven Schicht (342) durch die lokal auf der Oberfläche (343) der photosensitiven Schicht (342) auftreffende Lichtintensität des projizierten Lichstrahlbündels (161a) erfolgt. Exemplarisch zeigt Fig. 3 hierzu ausgehärtete Bereiche (344), die durch selektive Belichtung einer flüssigen photosensitiven Schicht (342) erzeugt wurden. Um eine dem gewünschten Druckbild entsprechende Siebdruckschablone herzustellen wird der Belichtungskopf (350) beispielsweise in mehreren parallelen Bahnen über die Oberfläche (343) geführt, um somit die gesamte Oberfläche (343) zu erfassen. Dabei wird der Belichtungskopf (350) innerhalb einer Bahn nur in der Richtung des Pfeils (324) und zwischen den einzelnen Bahnen in der Richtung senkrecht zur Zeichenebene bewegt. Grundsätzlich sind jedoch neben der Bewegung in parallelen Bahnen auch alle Arten von anderen geeigneten Bewegungsmustern des Belichtungskopfs (350) denkbar.

Als Trägerobjekt (342) für die flüssige photosensitive Schicht (342) ist in Fig. 3 exemplarisch ein Siebdruckgewebe (340) gezeigt, auf dem die flüssige photosensitive Schicht (342) aufgetragen wurde. Die Querschnitte der einzelnen Fasern (341) des Siebdruckgewebes (340) sind in Fig. 3 schematisch als ausgefüllte Kreise dargestellt. Das Siebdruckgewebe (340) ist zudem auf einem Siebdruckrahmen (nicht dargestellt) aufgespannt. Ohne weiteres könnte als Trägerobjekt jedoch auch eine Trägerfolie dienen und die hergestellte Siebdruckschablone nach dem Belichten von der Trägerfolie auf ein Siebdruckgewebe übertragen werden.

## Patentansprüche

1. Lichtquellen-Anordnung (100) umfassend mindestens eine Lichtquelleneinheit (110), mindestens eine Spiegeleinheit (120) und mindestens einen optischen Diffusor (130),
wobei die mindestens eine Lichtquelleneinheit (110) eine Vielzahl von gleichartigen Lichtquellen (111) umfasst, welche jeweils ein Maximum der abgestrahlten Lichtstärke entlang einer Richtung aufweisen und so angeordnet sind, dass die Richtungen mit maximaler Lichtstärke der jeweiligen Lichtquellen (111) im Wesentlichen parallel zueinander sind,
wobei die mindestens eine Spiegeleinheit (120) mindestens zwei ebene Spiegel (121) umfasst, welche im Wesentlichen parallel zueinander und versetzt zueinander angeordnet sind, sodass die mindestens zwei ebenen Spiegel (121) eine stufenförmige Anordnung bilden,
wobei die von der Vielzahl von Lichtquellen (111) ausgesandten Lichtstrahlen zumindest teilweise von den mindestens zwei ebenen Spiegeln (121) auf mindestens eine Eintrittsoberfläche (131) des mindestens einen optischen Diffusors (130) reflektiert werden, an der mindestens einen Eintrittsoberfläche (131) des mindestens einen optischen Diffusors (130) zumindest teilweise in das Volumen (132) des mindestens einen optischen Diffusors (130) eintreten, in dem Volumen (132) des mindestens einen optischen Diffusors (130) zumindest teilweise gestreut werden, und an mindestens einer Austrittsoberfläche (133) des mindestens einen optischen Diffusors (130) zumindest teilweise aus dem mindestens einen optischen Diffusor (130) als Lichtstrahlbündel (161) austreten.

2. Lichtquellen-Anordnung nach Anspruch 1,
wobei die Vielzahl von Lichtquellen (111) der mindestens einen Lichtquelleneinheit (110) mindestens zwei Gruppen von Lichtquellen (111) umfasst, wobei allen Lichtquellen (111) einer Gruppe gemeinsam ist, dass die von den jeweiligen Lichtquellen (111) in Richtung der maximalen Lichtstärke abgestrahlten Lichtstrahlen auf dem gleichen ebenen Spiegel (121) der mindestens einen Spiegeleinheit (120) auftreffen.

3. Lichtquellen-Anordnung nach Anspruch 2,
wobei alle Lichtquellen (111) einer Gruppe in einer Reihe angeordnet sind, falls die jeweilige Gruppe zwei oder mehr Lichtquellen (111) umfasst.

4. Lichtquellen-Anordnung nach Anspruch 2 oder 3,
wobei jede der mindestens zwei Gruppen von Lichtquellen (111) eine identische Anzahl von Lichtquellen (111) umfasst.

5. Lichtquellen-Anordnung nach einem der Ansprüche 1 bis 4,
wobei jede Lichtquelle (111) der mindestens einen Lichtquelleneinheit (110) eine Laserdiode (111) ist.

6. Lichtquellen-Anordnung nach einem der Ansprüche 1 bis 5,
wobei jede Lichtquelle (111) der mindestens einen Lichtquelleneinheit (110) Licht in einem Wellenlängenbereich zwischen 300 nm und 450 nm, bevorzugt zwischen 360 nm und 420 nm ausstrahlt.

7. Lichtquellen-Anordnung nach einem der Ansprüche 1 bis 6,
wobei die mindestens eine Lichtquelleneinheit (111) ferner eine gelochte Platte (112) umfasst, an der die Vielzahl von Lichtquellen (111) befestigt ist.

8. Lichtquellen-Anordnung nach einem der Ansprüche 1 bis 7,
wobei die mindestens eine Spiegeleinheit (120) ferner ein stufenförmiges Element (123) umfasst, welches die stufenförmige Anordnung der mindestens zwei ebenen Spiegel (121) definiert.

9. Lichtquellen-Anordnung nach einem der Ansprüche 1 bis 8,
wobei der mindestens eine optische Diffusor (130) zumindest in einigen Oberflächenbereichen, welche weder eine Eintrittsoberfläche (131) noch eine Austrittsoberfläche (133) darstellen, eine reflektierende Oberfläche (135) aufweist, sodass Lichtstrahlen, welche aus dem Volumen (132) des mindestens einen optischen Diffusors (130) auf die reflektierende Oberfläche (135) treffen, zumindest teilweise zurück in das Volumen (132) des mindestens einen optischen Diffusors (130) reflektiert werden.

10. Lichtquellen-Anordnung nach einem der Ansprüche 1 bis 9,
wobei die Lichtquellen-Anordnung (100) ferner mindestens ein optisches Bauteil (141), insbesondere mindestens eine Blende und/oder mindestens eine Linse (141), umfasst, welche/s entlang des Strahlengangs vor der mindestens einen Eintrittsoberfläche (131) des mindestens einen optischen Diffusors (130) angeordnet ist.

11. Lichtquellen-Anordnung nach einem der Ansprüche 1 bis 10,
wobei die Lichtquellen-Anordnung (100) ferner mindestens ein optisches Bauteil (151,152), insbesondere mindestens eine Blende (152) und/oder mindestens eine Linse (151), umfasst, welche/s entlang des Strahlengangs nach der mindestens einen Austrittsoberfläche (133) des mindestens einen optischen Diffusors (130) angeordnet ist.

12. Verfahren zur Herstellung einer Siebdruckschablone durch selektive Belichtung einer photosensitiven Schicht (342),
wobei mindestens ein Lichtstrahlbündel (161) von mindestens einer Lichtquellen-Anordnung (100) bereitgestellt wird,
wobei das mindestens eine bereitgestellte Lichtstrahlbündel (161) unter Verwendung mindestens eines Flächenlichtmodulators (310) auf die photosensitive Schicht (342) projiziert wird,
wobei der mindestens eine Flächenlichtmodulator (310) von mindestens einer Steuereinheit (330) so angesteuert wird, dass das projizierte Lichtstrahlbündel (161a) die photosensitive Schicht (342) entsprechend eines vorgegebenen Druckbilds selektiv belichtet,
**dadurch gekennzeichnet, dass**
das mindestens eine Lichtstrahlbündel (161) von einer Lichtquellen-Anordnung (100) nach einem der Ansprüche 1 bis 11 bereitgestellt wird.

13. Vorrichtung zur Herstellung einer Siebdruckschablone durch selektive Belichtung einer photosensitiven Schicht (342), insbesondere unter Durchführung eines Verfahrens nach Anspruch 12,
wobei die Vorrichtung (300) mindestens eine Lichtquellen-Anordnung (100), mindestens einen Flächenlichtmodulator (310) und mindestens eine Steuereinheit (330) umfasst,
**dadurch gekennzeichnet, dass**
die Vorrichtung (300) mindestens eine Lichtquellen-Anordnung (100) nach einem der Ansprüche 1 bis 11 umfasst.

## Geänderte Patentansprüche

### Geänderte Patentansprüche gemäss Regel 137(2) EPÜ.

1. Lichtquellen-Anordnung (100) umfassend mindestens eine Lichtquelleneinheit (110), mindestens eine Spiegeleinheit (120) und mindestens einen optischen Diffusor (130),
wobei die mindestens eine Lichtquelleneinheit (110) eine Vielzahl von gleichartigen Lichtquellen (111) umfasst, welche jeweils ein Maximum der abgestrahlten Lichtstärke entlang einer Richtung aufweisen und so angeordnet sind, dass die Richtungen mit maximaler Lichtstärke der jeweiligen Lichtquellen (111) im Wesentlichen parallel zueinander sind, wobei jede Lichtquelle (111) der mindestens einen Lichtquelleneinheit (110) eine Laserdiode (111) ist,
wobei die mindestens eine Spiegeleinheit (120) mindestens zwei ebene Spiegel (121) umfasst, welche im Wesentlichen parallel zueinander und versetzt zueinander angeordnet sind, sodass die mindestens zwei ebenen Spiegel (121) eine stufenförmige Anordnung bilden,
wobei die von der Vielzahl von Lichtquellen (111) ausgesandten Lichtstrahlen zumindest teilweise von den mindestens zwei ebenen Spiegeln (121) auf mindestens eine Eintrittsoberfläche (131) des mindestens einen optischen Diffusors (130) reflektiert werden, an der mindestens einen Eintrittsoberfläche (131) des mindestens einen optischen Diffusors (130) zumindest teilweise in das Volumen (132) des mindestens einen optischen Diffusors (130) eintreten, in dem Volumen (132) des mindestens einen optischen Diffusors (130) zumindest teilweise gestreut werden, und an mindestens einer Austrittsoberfläche (133) des mindestens einen optischen Diffusors (130) zumindest teilweise aus dem mindestens einen optischen Diffusor (130) als Lichtstrahlbündel (161) austreten.

2. Lichtquellen-Anordnung nach Anspruch 1,
wobei die Vielzahl von Lichtquellen (111) der mindestens einen Lichtquelleneinheit (110) mindestens zwei Gruppen von Lichtquellen (111) umfasst, wobei allen Lichtquellen (111) einer Gruppe gemeinsam ist, dass die von den jeweiligen Lichtquellen (111) in Richtung der maximalen Lichtstärke abgestrahlten Lichtstrahlen auf dem gleichen ebenen Spiegel (121) der mindestens einen Spiegeleinheit (120) auftreffen.

3. Lichtquellen-Anordnung nach Anspruch 2,
wobei alle Lichtquellen (111) einer Gruppe in einer Reihe angeordnet sind, falls die jeweilige Gruppe zwei oder mehr Lichtquellen (111) umfasst.

4. Lichtquellen-Anordnung nach Anspruch 2 oder 3,
wobei jede der mindestens zwei Gruppen von Lichtquellen (111) eine identische Anzahl von Lichtquellen (111) umfasst.

5. Lichtquellen-Anordnung nach einem der Ansprüche 1 bis 4,
wobei jede Lichtquelle (111) der mindestens einen Lichtquelleneinheit (110) Licht in einem Wellenlängenbereich zwischen 300 nm und 450 nm, bevorzugt zwischen 360 nm und 420 nm ausstrahlt.

6. Lichtquellen-Anordnung nach einem der Ansprüche 1 bis 5,
wobei die mindestens eine Lichtquelleneinheit (111) ferner eine gelochte Platte (112) umfasst, an der die Vielzahl von Lichtquellen (111) befestigt ist.

7. Lichtquellen-Anordnung nach einem der Ansprüche 1 bis 6,
wobei die mindestens eine Spiegeleinheit (120) ferner ein stufenförmiges Element (123) umfasst, welches die stufenförmige Anordnung der mindestens zwei ebenen Spiegel (121) definiert.

8. Lichtquellen-Anordnung nach einem der Ansprüche 1 bis 7,
wobei der mindestens eine optische Diffusor (130) zumindest in einigen Oberflächenbereichen, welche weder eine Eintrittsoberfläche (131) noch eine Austrittsoberfläche (133) darstellen, eine reflektierende Oberfläche (135) aufweist, sodass Lichtstrahlen, welche aus dem Volumen (132) des mindestens einen optischen Diffusors (130) auf die reflektierende Oberfläche (135) treffen, zumindest teilweise zurück in das Volumen (132) des mindestens einen optischen Diffusors (130) reflektiert werden.

9. Lichtquellen-Anordnung nach einem der Ansprüche 1 bis 8,
wobei die Lichtquellen-Anordnung (100) ferner mindestens ein optisches Bauteil (141), insbesondere mindestens eine Blende und/oder mindestens eine Linse (141), umfasst, welche/s entlang des Strahlengangs vor der mindestens einen Eintrittsoberfläche (131) des mindestens einen optischen Diffusors (130) angeordnet ist.

10. Lichtquellen-Anordnung nach einem der Ansprüche 1 bis 9,
wobei die Lichtquellen-Anordnung (100) ferner mindestens ein optisches Bauteil (151, 152), insbesondere mindestens eine Blende (152) und/oder mindestens eine Linse (151), umfasst, welche/s entlang des Strahlengangs nach der mindestens einen Austrittsoberfläche (133) des mindestens einen optischen Diffusors (130) angeordnet ist.

11. Verfahren zur Herstellung einer Siebdruckschablone durch selektive Belichtung einer photosensitiven Schicht (342),
wobei mindestens ein Lichtstrahlbündel (161) von mindestens einer Lichtquellen-Anordnung (100) bereitgestellt wird,
wobei das mindestens eine bereitgestellte Lichtstrahlbündel (161) unter Verwendung mindestens eines Flächenlichtmodulators (310) auf die photosensitive Schicht (342) projiziert wird,
wobei der mindestens eine Flächenlichtmodulator (310) von mindestens einer Steuereinheit (330) so angesteuert wird, dass das projizierte Lichtstrahlbündel (161a) die photosensitive Schicht (342) entsprechend eines vorgegebenen Druckbilds selektiv belichtet,
**dadurch gekennzeichnet, dass**
das mindestens eine Lichtstrahlbündel (161) von einer Lichtquellen-Anordnung (100) nach einem der Ansprüche 1 bis 10 bereitgestellt wird.

12. Vorrichtung zur Herstellung einer Siebdruckschablone durch selektive Belichtung einer photosensitiven Schicht (342), insbesondere unter Durchführung eines Verfahrens nach Anspruch 12,
wobei die Vorrichtung (300) mindestens eine Lichtquellen-Anordnung (100), mindestens einen Flächenlichtmodulator (310) und mindestens eine Steuereinheit (330) umfasst,
**dadurch gekennzeichnet, dass**
die Vorrichtung (300) mindestens eine Lichtquellen-Anordnung (100) nach einem der Ansprüche 1 bis 10 umfasst.
